# EUROPEAN PATENT SPECIFICATION

(11) **EP 1 063 875 B1**
(45) Date of publication and mention of the grant of the patent: **10.01.2007**
(21) Application number: 99122961.8
(22) Date of filing: 18.11.1999
(51) Int. Cl.: H05K 13/04

(54) **Surface mounting device**
Vorrichtung zur Oberflächenmontage
Dispositif de montage en surface

(30) Priority: 16.06.1999 KR 2248899
(43) Date of publication of application: 27.12.2000
(73) Proprietor: Mirae Corporation, Chunan-shi, Choongchungnam-do (KR)
(72) Inventor: Yi, Yun Hyung, Suji-eup, Yongin-si Kyungki-do (KR)
(74) Representative: Meissner, Bolte & Partner

(56) References cited:
- US-A- 5 203 061
- US-A- 5 860 208

## Description

### BACKGROUND OF THE INVENTION

### Field of the Invention

The present invention relates to a surface mounting device, and more particularly to a surface mounting device in which a working can be performed more efficiently and correctly by providing at least one or more moving means movable integrally or independently to a predetermined portion of a X-Y gantry.

### Description of the Prior Art

In general, a conventional surface mounting device of a semiconductor device is constructed so that a pattern for an electronic component is acknowledged by an image processing method and a position is determined for mounting on a printed circuit board thereby to be mount the component.

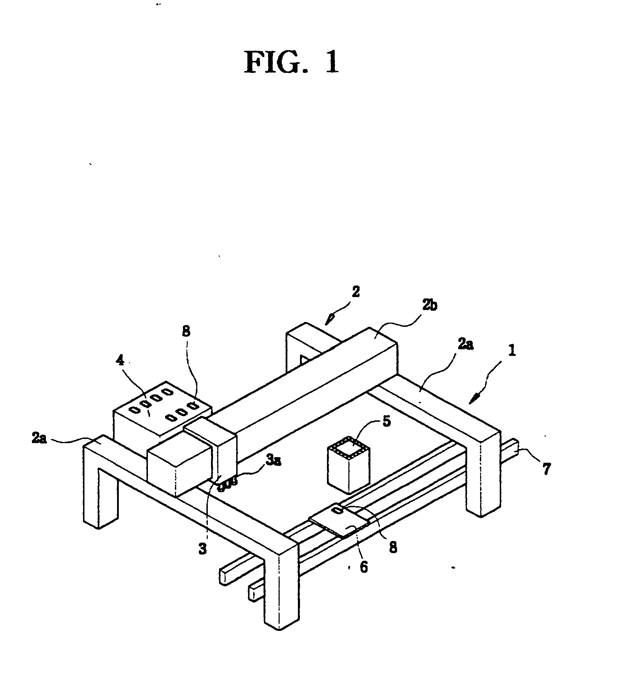

A conventional surface mounting device is shown in Fig. 1.

As shown in Fig. 1, the conventional surface mounting device 1 is comprised of a X-Y frame 2, a head 3 which is supported for moving in a X-Y direction; a component supplying portion 4, a position determining portion 5, and a conveyor 7 for carrying a printed circuit board 6. Furthermore, the X-Y frame 2 is comprised of a X frame 2b and a Y frame 2a.

An operation of the surface mounting device having the above construction is as follows.

When the X-Y frame 2 is controlled to operate by a driving means not shown, the head 3 is moved to an electronic component 8 to be mounted on the component supplying portion 4. At this time, the electronic component 8 is disposed within a subject area of a photographing means in the mounting direction.

Accordingly, the suction nozzle 3a grasps the electronic component by a vacant suction method according as the suction means, which connected to the suction nozzle 3a of the head 3, operates. Under this state, the head 3 moves to the position determining portion 5 to mount the component accordingly as the X-Y frame 2 is controlled to operate by the driving means.

Next, the head 3 moves to a position that is determined by the position determination portion 5 on the printed circuit board that is carried by the conveyor 7. Accordingly, the electronic component 8 grasped by the suction nozzle 3a of the head 3 is mounted.

The suction nozzle 3a of the head 3 allows the electronic component 8 to be released by the stop of the suction means connected thereto. By the foregoing operations, the one electronic component 8 is mounted on the printed circuit board 6.

The conventional surface mounting device includes the X-Y frame having a plurality of the suction nozzles. However, to mount the component sucked to the nozzle on the printed circuit board, only one component by one operation should be mounted on the printed circuit board by the operation of the X-Y frame.

This causes a production efficiency to be deteriorated. Further, if the X-Y frame is operated incorrectly, a mounting speed becomes low and if the X-Y frame is constructed to be large, it is hard to be satisfactory the speed and the correction thereof.

### SUMMARY OF THE INVENTION

Accordingly, the present invention has been invented to solve the above problems, it is an object to provide a surface mounting device in which a picking and placing operation for a component can be performed more efficiently by constructing in various form a moving means and a sub moving means.

Another object of the present invention is to provide a surface mounting device in which a precision can be improved by mounting a component by using a small gantry when a distance movement is necessary and by moving a plurality of the moving means integrally or independently within a predetermined working area.

To achieve the above objects, the present invention provides a surface mounting device as defined in claim 1.

### BRIEF DESCRIPTION OF THE DRAWINGS

Other objects and aspects of the invention will become apparent from the following description of embodiments with reference to the accompanying drawings in which:
Fig. 1 is a perspective view of a conventional surface mounting device.
Fig. 2 is a perspective view of the surface mounting device according to the present invention.
Fig. 3 is a view for moving means according to the present invention.
Fig. 4 is a view for moving means according to another embodiment of the present invention.
Figs. 5a, 5b and 5c are views for moving means according to the present invention.
Fig. 6 is a schematic view for a zooming function of the moving means according to the present invention.

### DETAILED DESCRIPTION OF THE INVENTION

Now, an example of a surface mounting device will be in detail described with reference to the drawings.

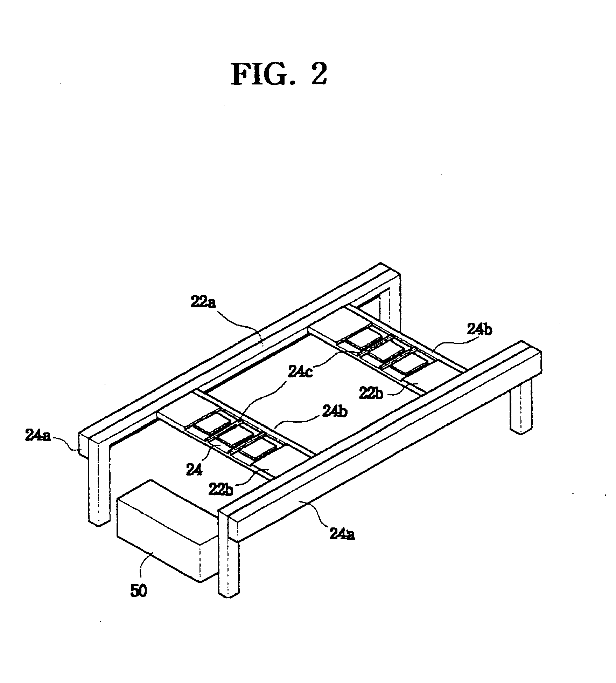

A surface mounting device according to the present invention is, as shown in Fig. 2, constructed so that Y-axis frame 22a is disposed to be crossed to a X-axis frame 22b. Here, it is described in case a dual gantry type is applied, however, the present invention can be applied to the single gantry.

The Y-axis frame 22a and a X-axis frame 22b are, at a certain portion thereof, disposed with a high speed linear motors 24a and 24b.

At this time, it is preferable that the linear motor 24a is disposed at every Y frame 22a to increase a precision although it can be disposed only one frame of the Y frame 22a.

Furthermore, the X frame 22b is, a certain portion thereof, disposed with a plurality of moving means 24. The moving means is disposed to be movable.

That is, the moving means 24 can be moved in a horizontal direction by the linear motor 24b and can be moved in a longitudinal direction by the linear motor 24c as a sub driving means.

The high speed linear motor 24c used is one selected among a surface motor, a step motor, a rotary motor, a means for converting a rotational movement to a linear movement.

The driving means 34 is, at a lower portion thereof, disposed with at least one manipulator 32. At this time, the manipulator 32 is, according to the user's desire, provided with means for picking and placing a component and provided with means for processing a component if necessary.

Furthermore, the manipulator 32 used has one or more head 42 and vision portions 52. The driving means for driving the manipulator 32 used is one selected among the surface motor, a linear motor, a means for converting a rotational movement to a linear movement.

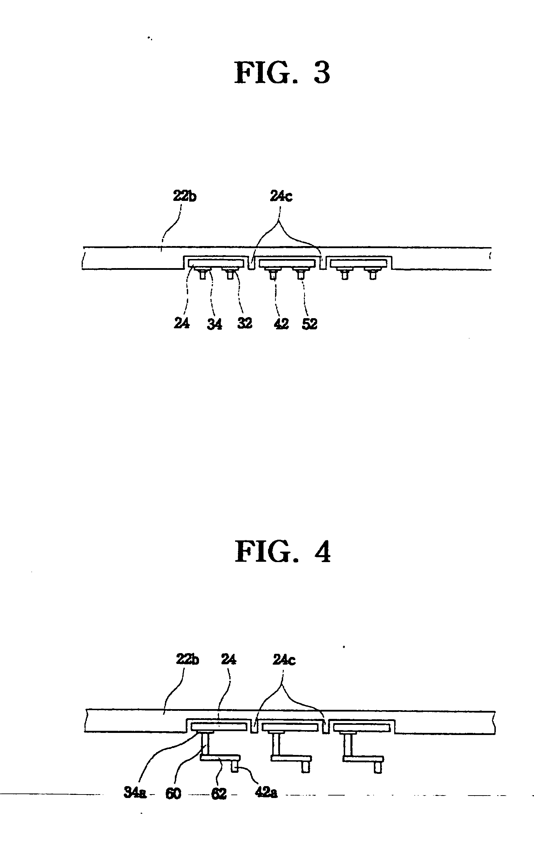

Meanwhile, as preferred embodiment of the present invention, the manipulator 32 is replaced with a bar 62 connected to an axis 60 thereto to move the head in left and right directions, as depicted in Fig. 4.

Furthermore, the axis 60 is rotated by the driving of the sub driving means 34a. The head 42a is constructed to move in left and right direction along the bar 62 unlike the head 42.

The bar 62 is disposed with the head 42a and is, at a certain portion thereof, disposed with at least one vision portion not shown.

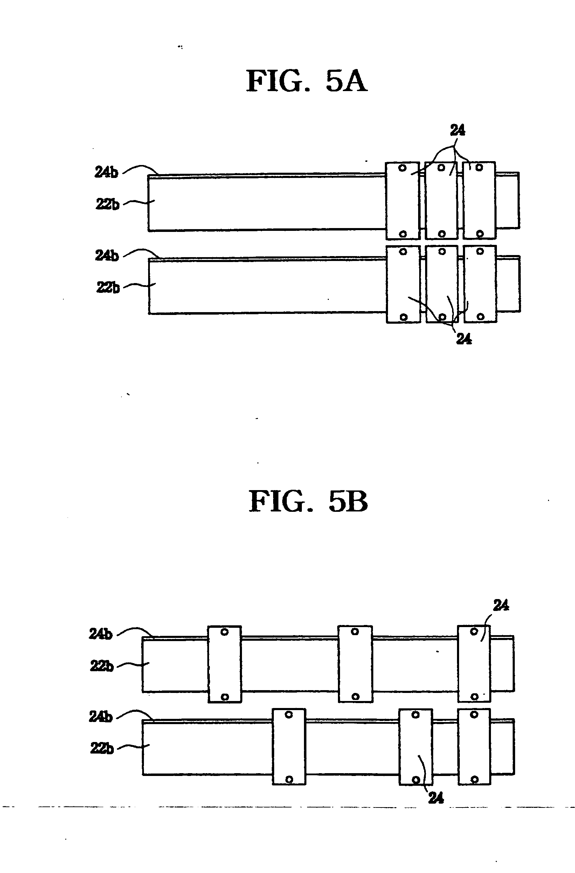

The moving means 24 is, as shown in Fig. 5a, provided in numbers on one side of the X frame 22b. Accordingly, as shown in Figs, 5b and 5c, they can be integrally or independently operated on each different positions of the X frame 22b.

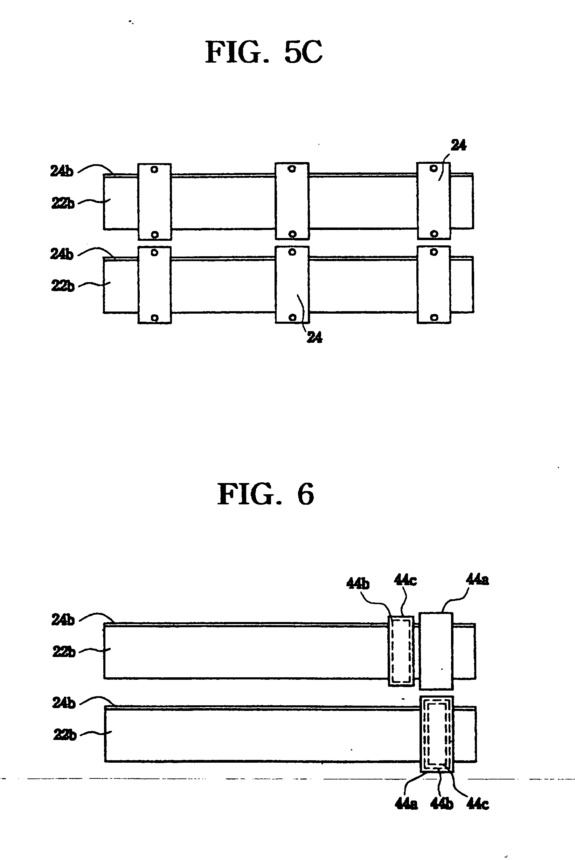

Meanwhile, the moving means can, as shown in Fig. 6, be constructed to be overlapping with a zoom shape. That is, the moving means 44a, 44b and 44c can be constructed to be overlapping some portions or the overall portions according to the user's desire.

Accordingly, it can be moved without difficulty for setting a working environment and control a working environment from outside by adjusting a program.

Furthermore, when the moving means 44a, 44b and 44c are used to be overlapping, the head or the vision portion must be constructed to be overlapped inside by the separate means. If possible, it is preferable that the vision portion is disposed at the outer peripheral surface of the moving means 44a, 44b and 44c.

An operation of the surface mounting device having the above construction will now be described.

As shown in Figs, 2 and 3, the X frame 22b is, at a certain portion thereof, disposed with a plurality of moving means 24 thereby to move in left and right direction since the moving means is, at one side thereof, disposed with the high speed linear motors 24b and 24c.

Furthermore, the moving means 24 is operated by the operation of the sub driving means 34. At this time, the head 42 grasps a component supplied from the component supplying portion 50 thereby to mount integrally or independently.

At this time, the Y frame 22a and the X frame 22b are first moved to the component supplying portion 50 and subsequently, the moving means 24 is moved. The movement in the X direction of the moving means 24 is possible by the high speed linear motor 24b and the movement in the Y direction is possible by another linear motor 24c.

Next, because the head 42 and the vision portion 52 are movable in a predetermined direction on the X-Y plane by the manipulator 32 disposed at the lower portion of the moving means 24, they can pick and place a component supplied from the component supplying portion 50 more easily.

Meanwhile, when the axis 60 and the bar 62 are used replacing the manipulator, they are rotated by the driving of the sub driving means 34a as shown in Fig. 4.

When the axis 60 is allowed to be rotated, the head 42a connected to the bar 62 is allowed to have a linear movement. Because the head 42a is allowed to perform a linear movement in left and right direction, a high precision can be achieved.

Furthermore, because the vision portion not shown is disposed at the rear of the head 42a and can easily check a grasp state for the component, the head 42a is moved integrally or independently and can pick and place a component more precisely.

The moving means 24 can, as shown in Figs. 5b and 5c, be operated to be integrated or separated.

When-the moving means 24 is, as shown in Fig. 5b, operated independently, a working speed can be increased because other workings are not overlapped. Furthermore, when the moving means is, as shown in Fig. 5c, operated integrally, a working efficiency can be increased because a repeated working is performed.

Meanwhile, when the user intends to use the moving means 44a, 44b and 44c by some or entire, as shown in Fig. 6, a working area can be decreased thereby to prevent the head from the unnecessary movement.

Having described the preferred embodiment of the invention with reference to the accompanying drawings, it is to be understood that various changes and modifications may be effected therein by one skilled in the art without departing from the scope of the invention as defined in the appended claims.

## Claims

1. A surface mounting device comprising:
at least one X, Y frame (22a, 22b) for moving in a predetermined direction;
at least one moving means (24) disposed at one of the X, Y frames and having at least one sub driving means (34a) for rotating an axis (60),
a bar (62) connected to the axis, wherein the bar is disposed with a head (42a).

2. The device in accordance with claim 1, wherein a certain portion of the bar is disposed with at least one vision portion (52).

3. The device of one of the preceding claims, wherein the head connected to the bar is allowed to have a linear movement.

4. The device in accordance with one of the preceding claims, further comprising main driving means disposed at a selected portion of the X, Y frame for driving said X, Y frame.

5. The device in accordance with one of the preceding claims, further comprising sub driving means (24b, 24c) for driving the moving means.

6. The device in accordance with one of the preceding claims, further comprising a component supplying portion (50) for supplying a component to the head.

7. The device in accordance with one of the preceding claims, wherein the at least one X, Y frame is provided for moving in the predetermined direction integrally or independently.

8. The device of one of the preceding claims, wherein the at least one X, Y frame comprises a pair of Y- axis frames separated from each other and at least one X-axis frame is disposed against the Y-axis frames for moving in a predetermined direction;
and wherein the main driving means is provided for driving independently the X-axis frame in a predetermined direction; and
the moving means is disposed at one side of the X-axis frame.

9. The device in accordance with one of the preceding claims, wherein each moving means is also configured to move along the X frame in a direction in which the at least one X frame is movable on the at least one Y frame.

10. The device in accordance with one of the preceding claims, wherein a plurality of moving means is mounted on each at least one X frame.

## Patentansprüche

1. Vorrichtung zur Oberflächenmontage, aufweisend:
mindestens einen X,Y-Rahmen (22a, 22b) zur Bewegung in einer vorbestimmten Richtung;
mindestens ein Bewegungsmittel (24), das an einem der X,Y-Rahmen angeordnet ist und mindestens ein Unterantriebsmittel (34a) zum Drehen einer Achse (60) aufweist,
eine Stange (62), die mit der Achse verbunden ist, wobei die Stange mit einem Kopf (42a) angeordnet ist.

2. Vorrichtung nach Anspruch 1, wobei ein bestimmter Teil der Stange mit mindestens einem Sichtteil (52) angeordnet ist.

3. Vorrichtung nach einem der vorhergehenden Ansprüche, wobei dem mit der Stange verbundenen Kopf eine lineare Bewegung erlaubt wird.

4. Vorrichtung nach einem der vorhergehenden Ansprüche, ferner aufweisend Hauptantriebsmittel, die an einem ausgewählten Teil des X,Y-Rahmens zum Antreiben dieses X,Y-Rahmens angeordnet sind.

5. Vorrichtung nach einem der vorhergehenden Ansprüche, ferner aufweisend Unterantriebsmittel (24b, 24c) zum Antreiben der Bewegungsmittel.

6. Vorrichtung nach einem der vorhergehenden Ansprüche, ferner aufweisend einen Komponentenzufuhrteil (50) zur Zufuhr einer Komponente zum Kopf.

7. Vorrichtung nach einem der vorhergehenden Ansprüche, wobei der mindestens eine X,Y-Rahmen zur integralen oder unabhängigen Bewegung in der vorbestimmten Richtung vorgesehen ist.

8. Vorrichtung nach einem der vorhergehenden Ansprüche, wobei der mindestens eine X,Y-Rahmen ein Paar von Y-Achsen-Rahmen aufweist, die voneinander getrennt sind, und mindestens ein X-Achsenrahmen gegen die Y-Achsenrahmen angeordnet ist zur Bewegung in einer vorbestimmten Richtung;
und wobei das Hauptantriebsmittel vorgesehen ist, um den X-Achsenrahmen unabhängig in einer vorbestimmten Richtung anzutreiben; und
das Bewegungsmittel an einer Seite des X-Achsenrahmens angeordnet ist.

9. Vorrichtung nach einem der vorhergehenden Ansprüche, wobei jedes Bewegungsmittel auch konfiguriert ist, um sich längs des X-Rahmens in einer Richtung zu bewegen, in welcher der mindestens eine X-Rahmen an dem mindestens einen Y-Rahmen bewegbar ist.

10. Vorrichtung nach einem der vorhergehenden Ansprüche, wobei eine Mehrzahl von Bewegungsmitteln an jedem mindestens einen X-Rahmen montiert ist.

## Revendications

1. Dispositif de montage en surface comportant :
au moins un cadre X, Y (22a, 22b) destiné à se déplacer dans une direction prédéterminée ;
au moins un moyen de déplacement (24) monté sur un des cadres X, Y et doté d'au moins un sous-ensemble de moyen d'entraînement (34a) destiné à faire tourner un axe (60) ;
une barre (62) reliée à l'axe, la barre étant pourvue d'une tête (42a).

2. Dispositif en accord avec la revendication 1, une certaine portion de la barre étant pourvue d'au moins une portion de vision (52).

3. Dispositif selon l'une des revendications précédentes, la tête reliée à la barre étant autorisée à avoir un mouvement linéaire.

4. Dispositif en accord avec une des revendications précédentes, comportant en outre un moyen d'entraînement principal monté sur une portion choisie du cadre X, Y pour entraîner ledit cadre X, Y.

5. Dispositif en accord avec l'une des revendications précédentes, comportant en outre des sous-ensembles de moyen d'entraînement (24b, 24c) destinés à entraîner le moyen de déplacement.

6. Dispositif en accord avec l'une des revendications précédentes, comportant en outre une portion d'amenée de composants (50) destinée à amener un composant vers la tête.

7. Dispositif en accord avec l'une des revendications précédentes, ledit au moins un cadre X, Y étant mis en place pour se déplacer dans la direction prédéterminée de façon intégrée ou indépendante.

8. Dispositif selon l'une des revendications précédentes, ledit au moins un cadre X, Y comportant une paire de cadres d'axe Y séparés l'un de l'autre et au moins un cadre d'axe X disposé contre les cadres d'axe Y pour se déplacer dans une direction prédéterminée ;
le moyen d'entraînement principal étant mis en place pour entraîner indépendamment le cadre d'axe X dans une direction prédéterminée ; et
le moyen de déplacement étant monté sur un côté du cadre d'axe X.

9. Dispositif en accord avec l'une des revendications précédentes, chaque moyen de déplacement étant également configuré pour se déplacer le long du cadre X dans une direction dans laquelle ledit au moins un cadre X est susceptible d'être déplacé sur ledit au moins un cadre Y.

10. Dispositif en accord avec l'une des revendications précédentes, une pluralité de moyens de déplacement étant montée sur chacun des au moins un cadre X.
